## Europäisches Patentamt
## European Patent Office
## Office européen des brevets

(11) Numéro de publication: **0 346 206**
**A1**

## (12) DEMANDE DE BREVET EUROPEEN

(21) Numéro de dépôt: **89401545.2**

(22) Date de dépôt: **05.06.89**

(51) Int. Cl.⁴: **H 01 R 13/66**
**H 01 R 23/72**

(30) Priorité: **07.06.88 FR 8807540**

(43) Date de publication de la demande:
**13.12.89 Bulletin 89/50**

(84) Etats contractants désignés: **DE IT NL**

(71) Demandeur: **THOMSON-CSF**
**51, Esplanade du Général de Gaulle**
**F-92800 Puteaux (FR)**

(72) Inventeur: **Val, Christian**
**THOMSON-CSF SCPI**
**CEDEX 67 - F-92045 Paris La Défense (FR)**

(74) Mandataire: **Benoit, Monique et al**
**THOMSON-CSF SCPI**
**F-92045 PARIS LA DEFENSE CEDEX 67 (FR)**

(54) **Connecteur actif pour carte de circuits imprimés.**

(57) La présente invention a pour objet un connecteur actif, c'est-à-dire comportant des moyens d'amplification, pour l'interconnexion de cartes de circuits imprimés.

Le connecteur comporte deux demi-grilles (51,52) de contact (5) reliées respectivement à chacune des cartes ($C_F$,$C_M$) à interconnecter; la connexion des demi-grilles est faite par l'intermédiaire de moyens d'amplification réalisés sous forme de circuit intégré (8), disposé sur un substrat (7) d'interconnexion.

FIG.2

EP 0 346 206 A1

**Description**

## CONNECTEUR ACTIF POUR CARTE DE CIRCUITS IMPRIMES

La présente invention a pour objet un connecteur pour la connexion de cartes portant des circuits imprimés.

Dans certains types d'applications à hautes performances, on utilise une structure formée d'une ou plusieurs cartes de circuits imprimés, dites cartes mères, portant en général des composants électroniques et sur lesquelles viennent se connecter à leur tour une ou plusieurs cartes, dites cartes filles. En général, l'implantation des composants et les interconnexions sont à haute densité sur ce type de cartes et leurs fréquences de fonctionnement sont élevées.

Les signaux transportés par la carte mère, sur un bus par exemple, doivent être prélevés à destination de la carte fille, et il est habituellement nécessaire de les amplifier avant traitement sur la carte fille.

Par ailleurs, quand les fréquences de fonctionnement deviennent élevées, il apparaît des réflexions parasites perturbant les signaux prélevés sur la carte mère quand la longueur de la liaison, du point de prélèvement sur la carte mère au point d'utilisation sur la carte fille, devient supérieure à un certain seuil, qui peut n'être que de quelques centimètres.

La présente invention a pour but d'assurer l'amplification des signaux prélevés sur la carte mère à l'intention de la carte fille, en minimisant ou évitant les limitations ou perturbations mentionnées ci-dessus.

A cet effet, l'invention a pour objet un connecteur assurant la connexion d'une carte fille à un circuit électrique dit carte mère, comportant des moyens d'amplification des signaux prélevés sur la carte mère. De ce fait, le connecteur est dit "actif".

Plus précisément, l'invention est un connecteur tel que défini par la revendication 1.

D'autres objets, particularités et résultats de l'invention ressortiront de la description suivante, donnée à titre d'exemple non limitatif et illustrée sur les dessins annexés, qui représentent :

- la figure 1, une vue schématique des liaisons entre un bus, porté par une carte mère, et une carte fille;

- la figure 2, une vue en coupe schématique d'un mode de réalisation du connecteur selon l'invention, assurant la liaison entre deux cartes de circuits imprimés;

- la figure 3a, une vue en coupe partielle d'un mode de réalisation du connecteur selon l'invention et la figure 3b, une vue de dessus de la figure précédente;

- la figure 4, une vue en coupe partielle d'un autre mode de réalisation du connecteur selon l'invention ;

- la figure 5, un autre de mode de réalisation du connecteur selon l'invention .

Sur ces différentes figures, les mêmes références se rapportent aux mêmes éléments.

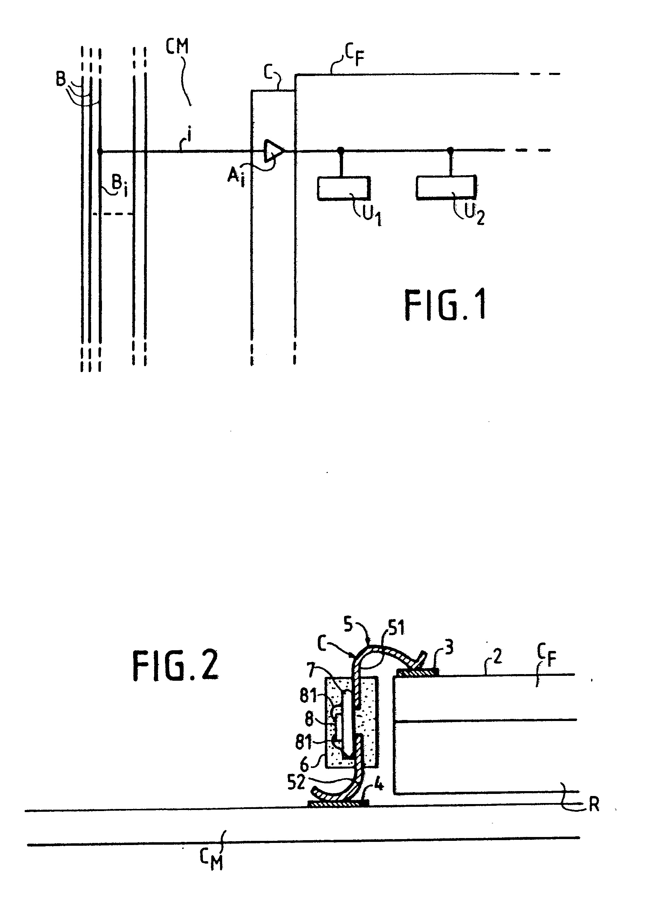

Sur la figure 1, on a donc illustré schématiquement les connexions entre une carte mère et une carte fille par l'intermédiaire du connecteur selon l'invention.

Ce qui est désigné dans la présente description par "carte mère", repéré $C_M$, porte des liaisons ou circuits électriques auxquels doivent être connectés des circuits portés par la carte fille $C_F$. La carte mère $C_M$ peut être constituée par une carte de circuits imprimés, formée classiquement par un substrat isolant portant des conducteurs imprimés formant un circuit électrique et, éventuellement, des composants électroniques, non représentés ici ; elle peut être également constituée par le fond du dispositif dans lequel sont maintenues une pluralité de cartes filles disposées parallèlement les unes aux autres, souvent appelé "fond de panier". On a représenté sur la figure un bus B, porté par la carte mère $C_M$, bus constitué comme il est usuel d'un ensemble de n conducteurs parallèles, chacun d'entre eux transportant par exemple un bit d'un mot binaire.

On a représenté également la carte fille $C_F$, carte de circuits imprimés qui porte des circuits électroniques, dont deux seulement sont représentés et repérés $U_1$ et $U_2$; chacun de ces circuits est destiné à recevoir par exemple le bit transporté par l'un des fils, repéré $B_i$, du bus B. La carte fille $C_F$ est reliée à la carte mère $C_M$ par l'intermédiaire d'un connecteur C, comportant selon l'invention des moyens d'amplification $A_i$ disposés sur chacune (ou sur certaines seulement) des connexions qu'il établit entre les deux cartes, comme représenté sur la figure pour la liaison i.

La figure 2 représente une vue en coupe d'un mode de réalisation du connecteur selon l'invention.

Sur cette figure, on retrouve les cartes mère $C_M$ et fille $C_F$ vues en coupe. La carte fille $C_F$ est par exemple disposée sur la carte mère $C_M$ par l'intermédiaire d'un dissipateur thermique R. Celle des faces, repérée 2, de la carte fille $C_F$ qui porte des composants porte également une série de zones de connexions dont l'une, 3, est représentée en coupe sur la figure 2. De la même manière, on a représenté une zone de connexion 4 de la carte mère $C_M$, le connecteur C assurant la liaison entre les zones telles que 3 et 4.

Le connecteur C comporte donc une pluralité de contacts métalliques tels qu'un contact 5 représenté sur la figure, assurant les liaisons entre les zones 3 et 4, l'ensemble des contacts, par exemple n contacts , disposés sensiblement parallèlement les uns aux autres, forme ce qu'on appelle une grille de contacts. Les contacts sont réalisés en un matériau électriquement conducteur et élastique, par exemple en cuivre-beryllium ; ils se présentent par exemple sous la forme de languettes. Dans sa région médiane, chacun des contacts 5 est interrompu. De la sorte, la grille de contacts 5 est formée de deux demi-grilles, repérées 51 et 52. La connexion électrique entre les deux demi-grilles 51 et 52 est assurée au moyen d'un substrat 7 portant au moins une pastille 8 de matériau semi-conducteur dans laquelle est réalisé au moins un circuit amplificateur, par exemple sous forme de circuit intégré. La pastille est connectée au substrat 7 par des fils conducteurs 81. Plus précisément, chacun des contacts d'une demi-grille est relié au contact correspondant de l'autre demi-grille par l'intermédiaire d'un circuit amplificateur de la pastille 8, via le substrat 7. L'ensemble est, dans ce mode de réalisation, enrobé dans une substance de protection 6 telle qu'un plastique moulé.

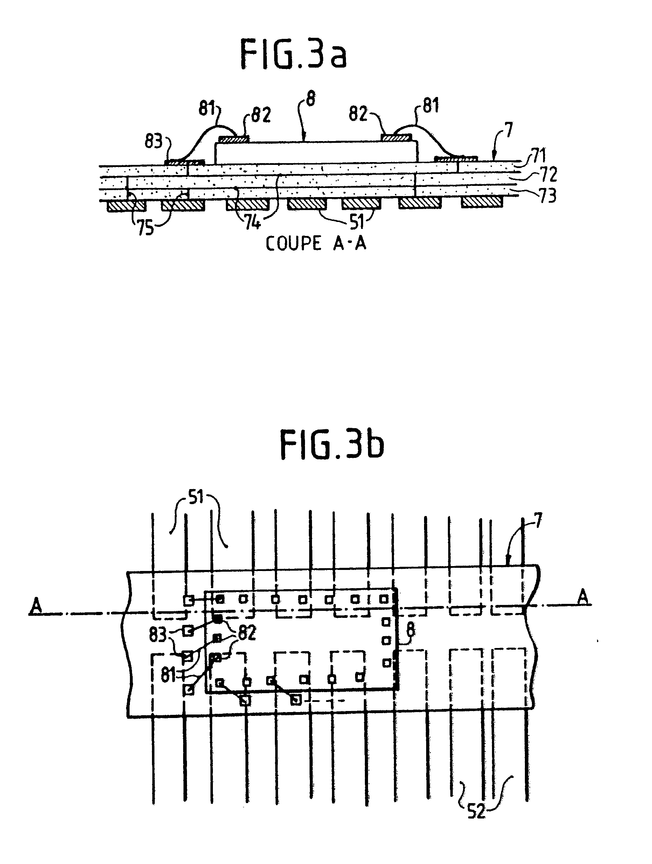

La figure 3a représente une vue en coupe partielle de la partie centrale d'un mode de réalisation du connecteur selon l'invention et la figure 3b, une vue de dessus de cette même partie centrale.

Sur ces figures, on retrouve le circuit intégré 8 ainsi que le substrat 7 et la grille de contacts 5 disposée de l'autre côté du substrat 7 par rapport au circuit 8. Le substrat 7 est par exemple multicouche, formé de trois couches repérées 71, 72, 73. Il peut être en époxy ou en alumine, par exemple. Le matériau d'enrobage (6, figure 2) n'est pas représenté ici.

Le circuit intégré 8 comporte une pluralité de circuits amplificateurs et des plots de connexion 82 qui sont reliés par les fils 81 à des plots de connexion 83 situés sur le substrat 7. Chacun des plots 83 est relié à l'un des contacts des demi-grilles 51 ou 52 par l'intermédiaire de pistes conductrices 74 disposées sur les couches 71-73 et de trous métallisés 75 traversant ces couches 71-73.

De la sorte, chacun des conducteurs de la demi-grille 51 est relié au conducteur correspondant de la demi-grille 52 par l'intermédiaire du circuit 8.

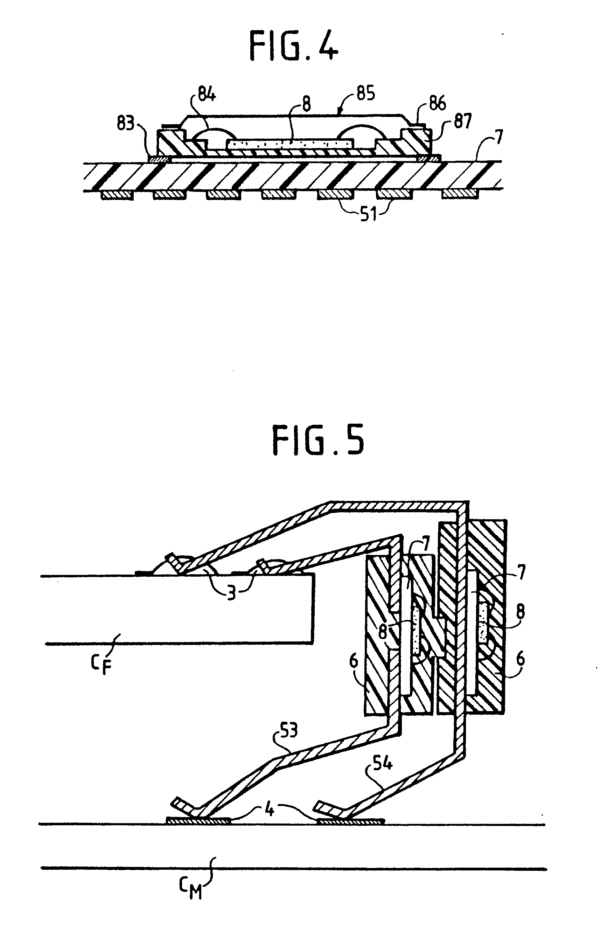

La figure 4 représente une vue en coupe partielle de la partie centrale d'un autre mode de réalisation du connecteur selon l'invention.

Sur cette figure, on retrouve le circuit intégré 8, le substrat 7 d'interconnexions (les interconnexions n'étant pas représentées) et par exemple la demi-grille de contacts 51.

Toutefois, dans ce mode de réalisation, la pastille 8 n'est pas directement reliée au substrat 7 mais est disposée dans un boîtier 85, du type "chip carrier" par exemple, qui assure la protection de la pastille 8 et sa connexion au substrat 7, rendant l'enrobage (6, figure 2) inutile.

Plus précisément, la pastille 8 est disposée sur l'embase 87 du boîtier 85, connectée à cette dernière par des fils 84, l'embase 87 assurant la connexion aux plots 83 du substrat 7. L'embase est recouverte de façon hermétique par un capot 86.

La figure 5 représente un autre mode de réalisation du connecteur selon l'invention.

Sur cette figure, on retrouve, vue en coupe, la carte mère $C_M$ et la carte fille $C_F$ portant les zones de connexions repérées respectivement 4 et 3. Le connecteur comporte toujours un ensemble de $n$ contacts mais ceux-ci sont par exemple maintenant répartis selon deux grilles différentes, repérées 53 et 54; chacune des grilles est, comme précédemment, composée de deux demi-grilles dont l'interconnexion est réalisée au moyen d'une pastille 8 de circuit intégré via un substrat 7, le tout étant enfermé par exemple dans un enrobage 6. Dans la variante de réalisation représentée sur la figure, la géométrie des enrobages 6 est telle qu'ils puissent être rendus mécaniquement solidaires l'un de l'autre, par encastrement par exemple.

A titre d'exemple, les contacts peuvent être brasés sur l'une des cartes, la carte $C_F$ par exemple, et seulement pressés sur l'autre (la carte mère $C_M$).

**Revendications**

1. Connecteur pour la connexion d'une carte de circuits imprimés dite carte fille ($C_F$) à un circuit électrique dit carte mère ($C_M$), caractérisé par le fait qu'il comporte une pluralité de contacts (5) dont les deux extrémités sont respectivement reliées électriquement à la carte mère et à la carte fille, et des moyens d'amplification d'un signal électrique, interposés entre les dites extrémités d'au moins l'un des contacts.

2. Connecteur selon la revendication 1, caractérisé en ce que les contacts sont disposés sensiblement parallèlement les uns aux autres pour former deux demi-grilles de contacts (51, 52), chacun des contacts d'une demi-grille étant relié par l'une de ses extrémités à l'une des cartes et, par l'autre extrémité, aux moyens d'amplification.

3. Connecteur selon la revendication 2, caractérisé en ce que les moyens d'amplification comportent au moins un circuit amplificateur disposé sur et relié électriquement à un substrat d'interconnexion (7), ce dernier assurant la connexion du circuit amplificateur avec un contact de chacune des demi-grilles.

EP 0 346 206 A1

FIG.1

FIG.2

# FIG.3a

COUPE A-A

# FIG.3b

# FIG.4

# FIG.5

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | US-A-3487269 (G. B. BUNN)<br>* colonne 1, ligne 66 - colonne 2, ligne 60; figures 1, 2 * | 1 | H01R13/66<br>H01R23/72 |
| A | FR-A-2587549 (LA RADIOTECHNIQUE)<br>* page 3, ligne 33 - page 4, ligne 12 *<br>* page 5, ligne 4 - page 6, ligne 2; figures 1-3 * | 1 | |
| A | EP-A-172090 (COMMISSARIAT A L'ENERGIE ATOMIQUE)<br>* page 3, ligne 4 - page 3, ligne 16; figure 1 * | 1 | |

DOMAINES TECHNIQUES
RECHERCHES (Int. Cl.4)

H01R
H05K

Le présent rapport a été établi pour toutes les revendications

| Lieu de la recherche | Date d'achèvement de la recherche | Examinateur |
|---|---|---|
| LA HAYE | 11 SEPTEMBRE 1989 | TAPPEINER R, |